# EUROPEAN PATENT APPLICATION

(11) **EP 0 969 522 A1**
(43) Date of publication of application: **05.01.2000**
(21) Application number: 98870147.0
(22) Date of filing: 03.07.1998
(51) Int. Cl.: H01L 31/052

(54) **A thin-film opto-electronic device and a method of making it**

(71) Applicant: INTERUNIVERSITAIR MICROELEKTRONICA CENTRUM VZW, 3001 Leuven (BE)
(72) Inventor: STALMANS Lieven, 3920 Lommel (BE); POORTMANS Jef, 3010 Leuven (BE); CAYMAX Matty, 3001Leuven (BE); NIJS Johan, 3210 Linden-Lubbeek (BE)
(74) Representative: Van Malderen, Michel

(57) **Abstract**

The present invention is related to a thin-film opto-electronic device and a method of fabricating the same. Particularly this thin-film opto-electronic device is fabricated on a Si-containing substrate (1). The thin-film material (3) is a crystalline semiconductor material. In order to increase the efficiency of this device a porous silicon layer (2) is applied between the thin-film (3) and the substrate (1). This porous silicon layer has both light reflecting and light diffusing properties thereby giving rise to light confinement in the thin-film.

## Description

### Field of the invention

The present invention is related to an efficient thin-film opto-electronic device on a low-cost Si-containing substrate. The method of fabricating such a device uses process steps similar to the ones used for the fabrication of integrated circuits. Of particular interest are opto-electronic devices like solar cells and LED's.

### Background of the invention

When analyzing the technology progress on solar cells, being one of the opto-electronic devices under consideration, one can observe that an important research effort has been put in the development of solar cells in thin crystalline Si-based layers deposited on Si-containing substrates. It is a common feeling that this technical field remains important towards the future and carries a long-term economical importance. However, thin-film solar cell structures on a Si-containing substrate suffer from an intrinsic lack of light confinement. To assure a sufficiently high efficiency, one has to succeed to increase the light confinement into the thin film and at the same time avoid absorption losses into the substrate. The solution of this problem provides a major opportunity for advances in the efficiency of Si-based solar cells. Particularly, by collecting and confining the incident light in a small material volume, diffusion length requirements for efficient charge collection are relaxed and the thickness of the active layer in the silicon solar cell can be drastically reduced.

Several solutions have been proposed to introduce or improve light confinement. However all these different solutions have in common that the thin-film material quality is reduced and/or the complexity of the fabrication process increases. Some of these solutions are:
a) grooving or texturing of the substrate prior to the thin-film deposition (as e.g. in US 4571448). This has only limited beneficial results. The first pass of the incoming light is increased but there is no back reflection. Moreover, this solution has a negative influence on the complexity of the fabrication process.
b) deposition of the thin-film on a substrate which has an intermediate oxide layer acting as backside reflector. However, the use of such an oxide implies a lower quality of the deposited material and is technologically complicated.
c) a substrate etch-back can be performed to thin the substrate in order to be able to use the backside of the substrate as a reflector. Such an etch-back process leads to a severely decreased mechanical stability, which is also undesirable.

Independently in another technical field, research is carried out on epitaxial growth on porous Si. An interesting observation is that it is possible to obtain high-quality thin films when depositing Si on a porous Si surface. This has resulted mainly in using this technique for silicon-on-insulator (SOI) applications. For these applications, the porous layer is a disposable layer since the porous layer is removed afterwards as e.g. in the United States patent US-5536361.

Recently epitaxial growth on porous Si has been applied also in the field of solar cells as in R. Brendel, "A novel process for ultra-thin monocrystalline silicon solar cells on glass", 14th European PV-Conference, Barcelona 1997, pp. 1354-1357. Here, a Si-film is grown on porous Si and transferred afterwards onto another substrate, i.e. a glass substrate. As in the SOI-application, the grown porous Si layer is a disposable layer.

### Aim of the invention

An aim of the invention is to achieve light confinement in a crystalline thin-film opto-electronic device being formed on a Si-containing substrate in order to increase the efficiency of this device. Typical thin-film materials are Si, Ge, SiGe and other III-V compound materials.

It is a further aim of the invention to achieve this light confinement without a substantial deterioration of the thin-film material quality and without substantially increasing the process complexity.

### Summary of the invention

In an aspect of the invention a crystalline thin-film opto-electronic device on a Si-containing substrate is disclosed. Particularly, this crystalline thin film is a semiconductor layer. In order to increase the efficiency of this device a porous silicon layer is applied between the thin-film and the substrate. This porous silicon layer has both light reflecting and light diffusing properties thereby giving rise to light confinement in the thin-film. Particularly, a thin-film opto-electronic device on a conductive silicon-containing substrate is disclosed comprising:
a porous silicon layer on said substrate, said porous silicon layer having both light diffusing and light reflecting properties;
a semiconductor layer on said porous silicon layer; and
at least one first region and at least one second region in said semiconductor layer, said first region of a first conductivity type acting as a light absorber, said second region having a conductivity of a second type, different from said first conductivity type, for contacting said thin-film opto-electronic device.

In an embodiment of the invention, the porous Si layer has a thickness in the range from 0.1 m to 1 m. The porosity has a value typically between 20% and 70%. This porosity can be tuned dependent on the desired performance being the overall efficiency of the device. An increase in porosity yields a better light confinement being beneficial for the efficiency but a decrease in the semiconductor layer material quality being detrimental for the efficiency. Furthermore the porosity can be influenced by the subsequent heat treatments as e.g. during the formation of the semiconductor layer. Particularly if temperatures above about 750 °C are applied, volatilization and coarsening can occur in the porous silicon layer. Examples of semiconductor layers are layers of silicon, Ge, SiGe or other III-V compound materials.

In another embodiment of the invention, the porous silicon layer comprises porous silicon parts and columnar conductive parts, said columnar conductive parts forming conductive connections between the substrate and the semiconductor layer. Particularly, these columnar conductive parts form conductive connections between the substrate and the first region of the semiconductor layer; said substrate having the same conductivity type as said first region, being either n-type or p-type, and said substrate being provided with a contact. The substrate is preferably a highly doped silicon substrate.

In another aspect of the invention, a method for fabricating a thin-film opto-electronic device on a conductive silicon-containing substrate is disclosed, comprising the steps of:
a) forming a porous silicon layer on said substrate such that said porous silicon layer acts as a light diffuser and as a light reflector;
b) growing a semiconductor layer on said porous silicon layer, said semiconductor layer comprising at least one first region and at least one second region being formed in said semiconductor layer, said first region of a first conductivity type acting as a light absorber, said second region of a second conductivity type, different from said first conductivity type, for contacting said thin-film opto-electronic device. The quality of the semiconductor layer grown depends on both the porosity of the initial porous layer and the growth temperature. Particularly if temperatures above about 750 °C are applied, volatilization and coarsening can occur in the porous silicon layer.

In another embodiment of the invention, the porosity of the initial porous layer is in the range from 20% to 70%, while the temperature during the subsequent growing step is preferably below about 750 °C. The porous silicon layer can be formed by exposing the substrate to an electrochemical treatment or a chemical treatment or spark erosion.

In another embodiment of the invention, the porous Si layer is formed by an electrochemical treatment, particularly by electrochemical anodization, e.g. in a HF-based electrolyte. The obtained thickness of the porous silicon layer depends on the anodization time and is typically in the range from 0.1 m to 1 m. The substrate is preferably a highly doped Si substrate having either a n-type or a p-type conductivity. The porous silicon layer formed can comprise porous silicon parts and columnar conductive parts, said columnar conductive parts forming conductive connections between the substrate and the first region of the semiconductor layer; said substrate and said first region having the same conductivity type.

In another embodiment of the invention, prior to the formation of the porous silicon layer a patterned mask layer is formed on the substrate to thereby define at least one first area and at least one second area in the substrate, said first area being uncovered, said second area being covered with said mask layer; thereafter said porous silicon layer is formed on said first area and said mask layer is removed from said second area; thereafter a semiconductor layer is grown on said second area and on said porous silicon layer thereby creating said columnar conductive parts.

In another embodiment of the invention a method is disclosed wherein the semiconductor layer is a Si or a Ge or a SiGe or a III-V compound layer being grown by means of chemical vapour deposition or physical vapour deposition or molecular beam epitaxy.

In another embodiment of the invention a method is disclosed wherein the substrate is not used for contacting the device. Particularly, the substrate can be lowly doped or not doped and/or isolated from the semiconductor layer. Instead, according to this method, at least one third region is formed in said first region for contacting said first region, said third region being isolated from said second region and having the same conductivity type as said first region.

### Brief description of the drawings

- Figure 1: depicts a Si-porous Si-Si multilayer structure according to an embodiment of the invention. The structure comprises a Si substrate (1), a Si semiconductor layer (3) and a porous Si layer (2) between the substrate and the semiconductor layer. In Fig. 1 a) the porous layer has only light reflecting properties, while in fig. 1 b) the porous layer has both light reflecting and light diffusing properties.
- Figure 2: depicts simulated reflectance data versus the wavelength. These simulation data are obtained from a specular simulation where the porous silicon layer only acts as a reflector and not as a diffuser. Observed is a clear interference pattern (4) and a total reflectance for the multilayer structure (as in Fig. 1 a)) which is larger than the reflectance of a pure Si substrate (5) (without porous Si layer), as indicated by the larger part of the reflectance curve situated above the Si-reflectance curve (dashed area) (6).
- Figure 3: depicts, according to an embodiment of the invention, measured reflectance data versus the wavelength. The measurement data (7) of the multilayer structure as depicted in fig. 1 as well as the Si reflectance curve (8) are presented.
- Figure 4: depicts, according to an embodiment of the invention, measurement data of the reflectance of the porous silicon layer for different heat treatments.
- Figure 5: depicts XTEM-pictures of a Si-porous Si-Si multilayer structure where the deposition of the Si semiconductor layer on top of the porous Si layer was performed using CVD at various temperatures and at different values of the porosity.

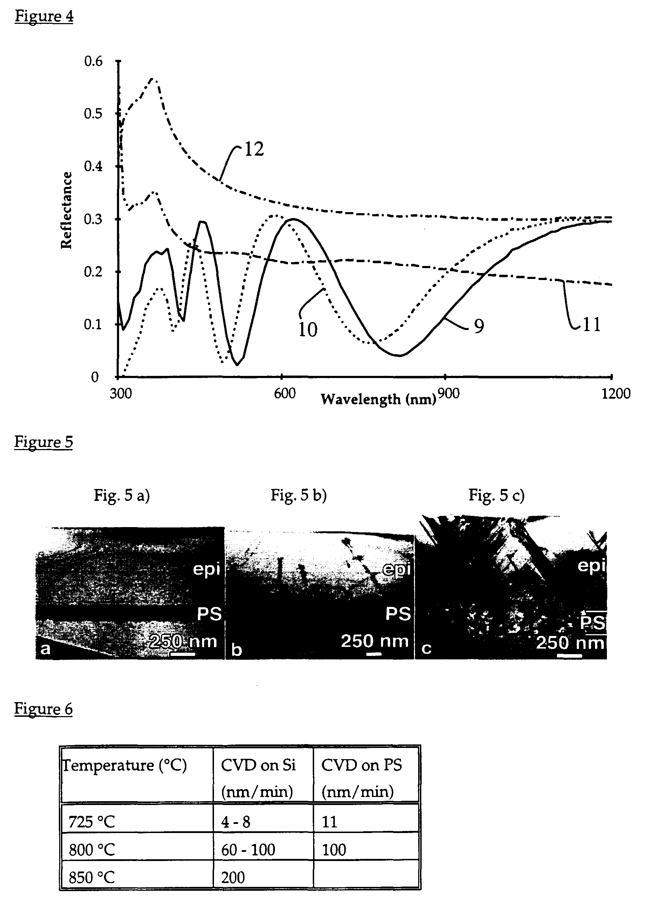

- In fig. 5 a): the deposition is performed at 725 °C with an initial porosity of 20%.
- In fig. 5b): the deposition is performed at 725 °C with an initial porosity of 60%.
- In fig. 5c): the deposition is performed at 800 °C with an initial porosity of 60%.
- Figure 6: presents, according to an embodiment of the invention, a table of some Si-deposition rates (using DCS as a source) on PS and on Si

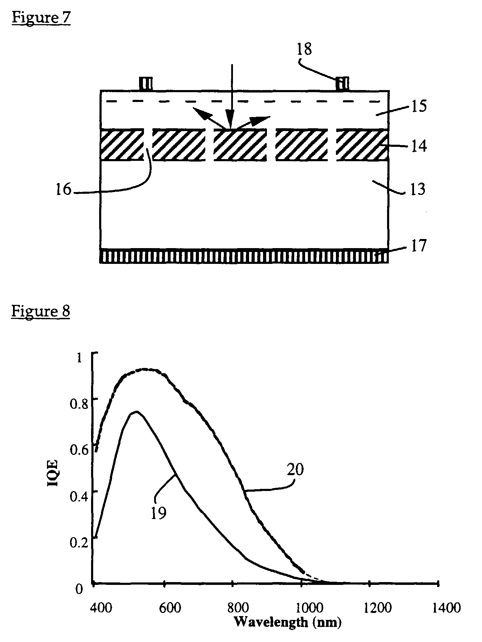

- Figure 7: depicts a cross-section of a solar cell, according to an embodiment of the invention.
- Figure 8: depicts both measured data of the IQE of the solar cell depicted in figure 7 and according to an embodiment of the invention, i.e. the realized epi-on-porous-silicon (19) cell as well as measurement data of a similar epi-on-Si solar cells (20) (without porous layer).

### Detailed description of the invention

In relation to the appended drawings the present invention is described in detail in the sequel. It is apparent however that a person skilled in the art can imagine several other equivalent embodiments or other ways of executing the present invention, the spirit and scope of the present invention being limited only by the terms of the appended claims.

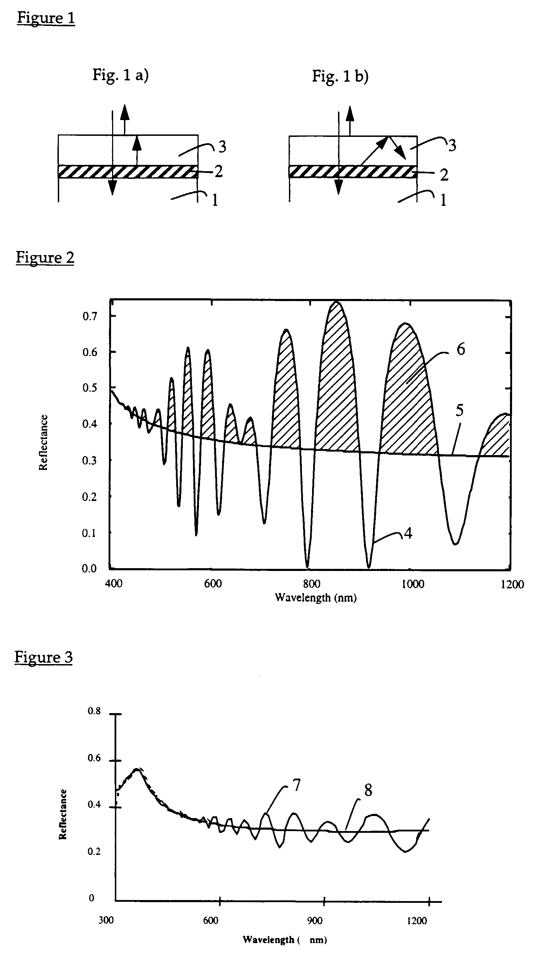

According to an embodiment of the invention, a porous silicon layer is incorporated in a thin-film opto-electronic device thereby giving rise to light confinement in the thin-film. To achieve a greater impact on the efficiency of this opto-electronic device, this porous silicon layer has to have both light reflecting and light diffusing properties. To evaluate these optical properties of the porous silicon layer, as an example, a comparison is made between simulated and measured reflectance characteristics of a typical multilayer structure (fig. 1) comprising a Si substrate (1), a Si semiconductor layer (3) and a porous Si layer (2) between the substrate and the semiconductor layer. If the porous layer scatters the reflected light (fig. 1b)), i.e. acts at the same time as a light reflector and as a light diffuser, a large part of the light returns at the surface of the semiconductor layer outside the escape cone and therefore remains inside the Si semiconductor layer, giving rise to a lower total reflectance as compared to a specular simulation (fig. 1a)) where the porous silicon layer acts only as a light reflector and give rise mainly to a coupling out of the reflected light at the front surface. In fig. 2 simulation data are shown, using the layer thickness as derived from XTEM. These simulation data are obtained from a specular simulation where the porous silicon layer only acts as a reflector and not as a diffuser. Observed is a clear interference pattern (4) and a total reflectance for the multilayer structure which is larger than the reflectance of a pure Si substrate (5) (without porous Si layer), as indicated by the larger part of the reflectance curve situated above the Si-reflectance curve (dashed area) (6).

These simulated data are to be compared with measured curves as depicted in fig. 3. In the measured case interference is observed as well, which indicates that the porous layer remains present (fig. 3) and affects the reflectance characteristic. However the real situation (7) differs from the simulated one with respect to the total reflectance which is smaller as compared to the simulated case since the area of the total reflectance above and below the Si reflectance curve is comparable. In other words the light is confined in the semiconductor layer and therefore it is clear that the porous Si layer also acts as a light diffuser. The measured total ('average') reflectance approaches the Si-reflectance (8) which is the lower-limit corresponding to the situation where only the light from the first air-Si reflection is measured

In another embodiment of the invention, as an example, a particular opto-electronic device, i.e. a solar cell (fig. 7) and the detailed process flow to fabricate that opto-electronic device according to the method of the present invention is considered. The starting material is a Si-containing substrate (13). According to this example, a highly doped p-type conductivity six inch silicon wafer is chosen with an epitaxial Si layer of 10 µm on top. This epitaxial layer has also a p-type conductivity at a level of 8x1018 cm-3.

Further according to the example, prior to the formation of a porous silicon layer a patterned mask layer is formed on the substrate, i.e. on the epitaxial layer, to thereby define at least one first area and at least one second area in the substrate. This first area is uncovered, while the second area is covered with the mask layer. Particularly, a nitride layer is used as a mask layer. In fact, first the six inch wafers were diced because for this particular experiment the maximum area was limited because of the size requirements for the porous Si formation. Particularly, squares with an area of 5 cm by 5 cm are created. Further processing is performed on these squares. A nitride layer having a thickness of 500 nm is deposited. In order to pattern this nitride layer, first a resist layer is deposited on the nitride layer. This resist layer is patterned by a sequence of at least a lithographic and a development step. Then the uncovered areas of the nitride layer are removed by means of a buffered HF step for 11 minutes. Thereafter, the remaining of the resist layer is removed using a acetone/IPA based rinse step.

In the next step of the example, a porous Si layer (14) is formed on the uncovered areas. A small portion of the substrate, i.e. the covered areas being about 4%, of the substrate is not converted into porous Si to provide conductive connections which allow the use of a cell structure with a back contact. This can e.g. be done by an electrochemical treatment or a chemical treatment or spark erosion. Particularly, the porous layer is formed by electrochemical anodization in a HF-based electrolyte. The anodization time is adjusted to obtain a layer thickness of approximately 350 nm. In fact a 15 seconds anodization is performed in an electrolyte comprising HF (50%), H2O and ethanol at a ratio of 1:1:2. Finally, the nitride is removed from the second areas.

If an electrochemical anodization is used and/or if one wants to make contact to the opto-electronic device via the substrate, preferably highly doped Si substrates, are used as e.g. in the example. At first, if a highly doped substrate is used, then no backside metal contact is required for the anodization. The presence of metal can be incompatible with the subsequent growth process of the semiconductor layer, especially in case this growth is performed using a chemical vapor deposition technique (CVD). Secondly, the formation of a porous Si layer on a highly doped material results in mesoporous Si which is the preferred type of porous material for the subsequent CVD-growth in view of the epitaxial quality of the grown semiconductor layer.

Further according to the example, a semiconductor layer (15) is grown on said second area and on said porous silicon layer thereby creating columnar conductive parts (16) in the porous Si layer between the grown semiconductor layer and the substrate. Particularly, first the surface of the porous Si layer is pre-treated by an exposure to a 2 % HF-based solution during 15 seconds followed by a short rinse in diluted water. Then, a crystalline semiconductor layer, i.e. a Si layer, is grown on the porous Si layer in an Epsilon-One tool, which is a commercially available single wafer chemical vapour deposition (CVD) epitaxial reactor manufactured by ASM Epitaxy. It consists of a horizontal, lamp heated quartz chamber with a SiC coated graphite susceptor. Load locks and very clean gases allow to grow high quality epitaxial monocrystalline and polycrystalline material in a wide range of temperatures. The reactor is operated at a reduced pressure (RP), typically 40 torr. SiH2Cl2 (DCS) is used as Si source gas, which is diluted in a flow of H2 as carrier gas.

The temperature according to the example is 800 °C. The time between the porous Si formation and the loading into the CVD-system is kept as short as possible to avoid ageing. The growth process is a single step process. In the first phase of the growth process the first region is formed. This first region, being the absorber region has a p-type conductivity and comprises a first and a second sub-layer. The first sub-layer has a thickness of 0.5 µm and an impurity level of 3 x 1019 cm-3 and is merely introduced to act as an electrical back-surface-field. The absorption mainly takes place in the second sub-layer having a thickness of 2 µm and an impurity level of 1 x 1016 cm-3. In the second phase of the growth process the second region is introduced with a n-type conductivity for contacting the solar cell. This second region has a thickness of 0.3 µm and an impurity level of 3x1019cm-3.

A number of heating cycles (fig. 4) is performed in order to assess the effects of the heat treatment, during growth of the semiconductor layer, on the properties of the porous Si layer formed. The porous Si reflectance (9), which is strongly dependent on the structural characteristics of the porous Si layer, remains virtually unaltered after a thermal anneal in H2-environment up to 725 °C (10). At higher temperatures however, coarsening of the porous layer occurs and the porous layer is volatilized in the strongly reducing ambient. As a result, the typical interference pattern in the reflectance disappears and the reflectance (11) is uniformly lowered compared to the Si-reflectance (12) due to the roughened surface. The coarsening and volatilization of the porous layer during a heat treatment are two distinct phenomena. An important issue herein is whether the porous layer is in direct contact with the H2-ambient. An experiment in which a porous layer is subjected to an heat treatment, a deposition, or a combined deposition and heat treatment, reveals that coarsening is present in all cases but that volatilization only occurs during heating since in both other cases the porous layer is covered by a protecting Si-cap. Furthermore heating tests on porous layers in an argon-ambient do not reveal any change in reflectance up to 1000 °C, which also points to the detrimental role of H2 on the porosity during annealing especially at elevated temperatures. Therefore, preferably the use of H2 as a carrier gas is avoided or in case H2 is in the ambient temperatures below 750 °C are recommended.

Crystalline silicon is obtained when applying thermal CVD on a porous surface layer. The epitaxial quality however depends on both the porosity of the initial porous Si layer and the deposition temperature (fig. 5). When depositing at 725 °C, an increase of the initial porosity from 20% (Fig. 5a)) to 60% (Fig. 5b)) increases the number of crystallographic defects. The defect density further increases when the deposition temperature is increased. An increase of the deposition temperature to 800 °C e.g. for the layer with an initial porosity of 60% results in strongly defected Si (fig. 5c)). Further analysis (fig. 6) of the deposited Si-layer thickness (using XTEM) reveals that the CVD-deposition rates on porous Si (PS) are comparable to the values obtained on Si. This is expected since the reflectance of a Si-on-porous-Si structure quickly evolves to the Si-reflectance. Hence no additional light absorption (which might increase the material temperature) occurs. Furthermore the values for the heat conductivity of porous Si which have been reported in literature, e.g. in V. Lysenko et al., "Heat transfer in porous silicon", 1st Porous Semiconductors-Science & Technology Conference, Mallorca pp. 105-106 (Meeting Abstracts) (1998), for mesoporous Si, i.e. ∼ 80-100 W/mK, are close to the value reported for Si 148 W/mK. Therefore any temperature difference within the opto-electronic device will be quickly balanced. According to the example a temperature of 800 °C is combined with an ambient comprising H2, the porous layer is still intact but the grown Si semiconductor layer is heavily defected which negatively influences the cell performance.

Further according to the example (fig. 7), after the growth of the Si semiconductor layer comprising multiple sub-layers, an Al metal contact (17) is formed at the backside of the substrate by evaporation. A low-temperature bulk- and surface-passivation scheme consisting of a plasma-hydrogenation for bulk passivation and a remote-plasma nitride deposition for surface passivation is applied. Followed by a sintering step and the formation of a multilayer metal pattern (18), i.e. 80 nm Ti, 50 nm Pd - and 5 µm Ag, on front side of the substrate.

Some of the characteristics of the solar cell formed in the example are presented. For comparison a similar solar cell is formed on a monocrystalline Si substrate as well (without porous Si layer). However no fundamental comparison is possible on the level of cell performance because of the applied CVD conditions in the example yielding strongly defected Si in the porous silicon case. (The temperature was too high or one had to omit the hydrogen.) Figure 8 shows the IQE of the realized epi-on-porous-silicon (19) and epi-on-Si solar cells (20). The low over-all response for the epi-on-PS cell (19) is due to a low bulk diffusion length being a consequence of the large defect density as is clearly pointed out by dark current analysis. Furthermore, simulations of the epi-on Si cell coincide with the measurements, whereas there is a misfit of about 22% in short-circuit current between the measurements and the simulations of the epi-on-porous-Si cell. This misfit is attributed to an increased optical absorption due to light confinement within the thin Si-film on top of the porous layer. This is a clear indication that the porous Si layer acts at the same time as a reflector and as a diffuser. Improving the quality of the epitaxially-grown Si will definitely lead to a cell structure with a better performance. A clear way towards higher-quality Si-epitaxy is by reducing the deposition temperature in order to avoid the drastic reorganization of the porous material. Lowering the temperature however should not be at the expense of a decreased deposition rate in order to maintain the economical feasibility.

## Claims

1. A thin-film opto-electronic device on a conductive silicon-containing substrate comprising:
a porous silicon layer on said substrate, said porous silicon layer having both light diffusing and light reflecting properties;
a semiconductor layer on said porous silicon layer; and
at least one first region and at least one second region in said semiconductor layer, said first region of a first conductivity type acting as a light absorber, said second region having a conductivity of a second type, different from said first conductivity type.

2. A device as recited in claim 1, where said semiconductor layer is a layer selected from a group comprising silicon, GaAs, SiGe and Ge.

3. A device as recited in claim 1, where said porous silicon layer has a thickness in the range from 0.1 µm to 1 µm.

4. A device as recited in claim 1, where said semiconductor layer has a thickness in the range from 0.1 µm to 10 µm.

5. A device as recited in claim 1, where said porous silicon layer has a porosity in the range from 20% to 70%.

6. A device as recited in claim 1, where the substrate is a highly doped silicon substrate.

7. A device as recited in claim 6, where said porous silicon layer comprises porous silicon parts and columnar conductive parts, said columnar conductive parts forming conductive connections between the substrate and the semiconductor layer.

8. A device as recited in claim 7, where said columnar conductive parts form conductive connections between the substrate and the first region of the semiconductor layer; said substrate having the same conductivity type as said first region, being either n-type or p-type, and being provided with a contact.

9. A device as recited in claim 8, where said device is a solar cell.

10. A device as recited in claim 1, where contacts are provided on said first region of said thin-film opto-electronic device.

11. A method for fabricating a thin-film opto-electronic device on a conductive silicon-containing substrate comprising the steps of:
a) forming a porous silicon layer on said substrate such that said porous silicon layer acts as a light diffuser and as a light reflector;
b) growing a semiconductor layer on said porous silicon layer, said semiconductor layer comprising at least one first region and at least one second region being formed in said semiconductor layer, said first region of a first conductivity type acting as a light absorber, said second region of a second conductivity type, different from said first conductivity type.

12. A method as recited in claim 11, wherein said porous silicon layer is formed by exposing the substrate to an electro-chemical treatment or a chemical treatment or spark erosion.

13. A method as recited in claim 11, wherein said semiconductor layer is a Si or a SiGe or a GaAs layer being grown by means of chemical vapour deposition or physical vapour or molecular beam epitaxy.

14. A method as recited in claim 11, wherein said porous silicon layer has a thickness in the range from 0.1 µm to 1 µm and a porosity in the range from 20% to 70%.

15. A method as in claim 11, wherein the porous silicon layer formed comprises porous silicon parts and columnar conductive parts, said columnar conductive parts forming conductive connections between the substrate and the first region of the semiconductor layer; said substrate and said first region having the same conductivity type.

16. A method as recited in claim 15, wherein prior to the formation of the porous silicon layer a patterned mask layer is formed on the substrate to thereby define at least one first area and at least one second area in the substrate, said first area being uncovered, said second area being covered with said mask layer; thereafter said porous silicon layer is formed on said first area and said mask layer is removed from said second area; thereafter a semiconductor layer is grown on said second area and on said porous silicon layer thereby creating said columnar conductive parts.

17. A method as recited in claim 11, wherein at least one third region is formed in said first region for contacting said first region, said third region being isolated from said second region and having the same conductivity type as said first region.
